# DEMANDE DE BREVET EUROPEEN

(11) **EP 1 727 276 A1**
(43) Date de publication de la demande: **29.11.2006**
(21) Numéro de dépôt: 06114520.7
(22) Date de dépôt: 24.05.2006
(51) Int. Cl.: H03B 29/00

(54) **Générateur d'un flux numérique pseudoaléatoire**

(30) Priorité: 25.05.2005 FR 0551377
(71) Demandeur: ST MICROELECTRONICS S.A., 92120 Montrouge (FR); UNIVERSITE D'AIX-MARSEILLE I, 13331 MARSEILLE CEDEX (FR)
(72) Inventeur: Kussener, Edith, 83200 Le Revest les Eaux (FR); Telandro, Vincent, 83000 Toulon (FR); Chaillan, Fabien, Avenue des Prats 83110 Sanary sur Mer (FR)
(74) Mandataire: de Beaumont, Michel

(57) **Abrégé**

L'invention concerne un procédé et un circuit de génération d'un flux numérique pseudoaléatoire comportant un oscillateur (2) à polarisation commandable par une source de polarisation analogique (5). La polarisation de l'oscillateur (2) est commandée au moyen d'un signal (Imod) en paliers dont la dureé des paliers varie de façon pseudoaléatoire et contînue dans un intervalle donné et dont l'amplitude des paliers varie également de façon pseudoaléatoire et contînue dans un intervalle donné.

## Description

### Domaine de l'invention

La présente invention concerne de façon générale les circuits électroniques et plus particulièrement la génération d'un flux numérique pseudoaléatoire.

L'invention s'applique notamment aux circuits sécurisés, par exemple de type à carte à puce, mettant en oeuvre des algorithmes de chiffrement, d'authentification, d'identification, etc. requérant des données pseudoaléatoires.

Un autre exemple d'application de la présente invention concerne la génération d'un signal d'horloge à sauts de fréquence pseudoaléatoires.

### Exposé de l'art antérieur

On connaît de nombreuses méthodes et circuits pour générer de façon matérielle ou logicielle des flux numériques pseudoaléatoires.

L'invention concerne plus particulièrement les générateurs faisant appel à des moyens matériels plutôt qu'à des algorithmes exécutés par un microcontrôleur, les méthodes logicielles souffrant généralement d'être déterministes.

Parmi les solutions matérielles connues, certaines mettent en oeuvre des moyens exclusivement numériques, par exemple un registre à décalage à rétroaction linéaire (LFSR ou Linear Feedback Shift Register). D'autres exploitent une source analogique, par exemple une source de bruit naturel lié au bruit thermique d'une résistance ou d'une diode, ou l'échantillonnage d'un oscillateur relativement rapide par un oscillateur relativement lent.

Une autre solution à laquelle s'applique plus particulièrement la présente invention utilise un oscillateur à polarisation commandable.

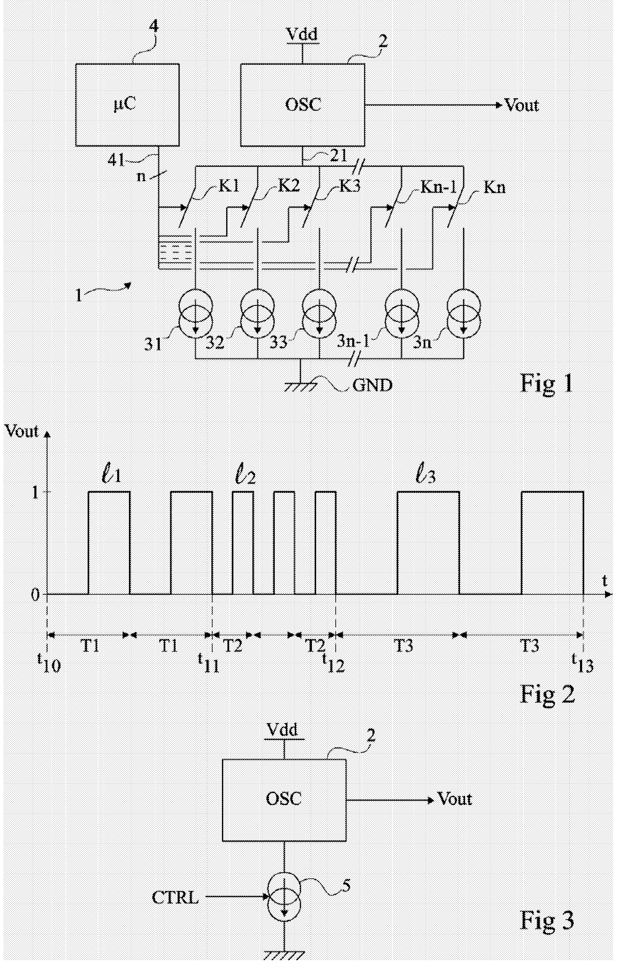

La figure 1 représente, de façon très schématique et sous forme de blocs, un exemple classique de circuit 1 de génération d'un signal numérique pseudoaléatoire Vout basé sur la polarisation d'un oscillateur 2 (OSC) alimenté par une tension continue Vdd. Cette polarisation est effectuée au moyen de plusieurs sources de courant 31, 32, 33, 3n-1 et 3n connectées en parallèle entre une borne 21 de prélèvement d'un courant de polarisation et la masse, chaque source de courant étant individuellement en série avec un commutateur K1, K2, K3, Kn-1 et Kn de commande. Les n interrupteurs Ki sont commandés par un circuit numérique 4 de type microcontrôleur (µC) dont le rôle est de provoquer des sauts temporels pseudoaléatoires dans la polarisation de l'oscillateur 2 par la commande des différents interrupteurs. Généralement, les sources de courant 3i absorbent des courants fixes de différentes valeurs, chacune d'entre-elles étant commandée individuellement et de façon séparée par le microcontrôleur 4 pour que les sources de courant polarisent l'oscillateur individuellement et successivement. On obtient donc un maximum de 2ⁿ-1 combinaisons. L'oscillateur 2 est, par exemple, un oscillateur en anneau.

La figure 2 illustre, par un chronogramme, un exemple d'allure de signal Vout fourni par le générateur 1 de la figure 1. La valeur du courant de polarisation conditionne les périodes T1 (source 31), T2 (source 32 de courant supérieur à celui de la source 31), T3 (source 33 de courant inférieur à celui de la source 31), etc. successives de l'oscillateur et les commutations (instants t10, t11, t12 et t13) entre les sources de courant conditionnent les durées respectives des trains d'impulsions de périodes T1, T2, T3, etc. Le signal Vout est un signal numérique de fréquence pseudoaléatoire et à sauts temporels pseudoaléatoires.

Si, comme cela est représenté, le délai maximal entre les commutations des interrupteurs est supérieur au temps de stabilisation de l'oscillateur 2, on obtient un signal d'horloge à sauts de fréquence pseudoaléatoires.

A l'inverse, si le délai maximal entre les commutations des interrupteurs est inférieur au temps de stabilisation de l'oscillateur, on obtient un signal numérique pseudoaléatoire qui, exploité à fréquence fixe par un circuit aval (non représenté), constitue un signal de données numériques pseudoaléatoires.

Un inconvénient est que la commande des interrupteurs Ki effectuée par le microcontrôleur 4 respecte un algorithme de commande pour contrôler un nombre déterminé de sources de polarisation. Un tel algorithme est forcément déterministe, ce qui nuit au caractère aléatoire du flux numérique généré.

### Résumé de l'invention

La présente invention vise à proposer un générateur d'un flux numérique pseudoaléatoire qui pallie tout ou partie des inconvénients des oscillateurs connus.

L'invention vise plus particulièrement à proposer une solution basée sur un oscillateur à polarisation commandable.

L'invention vise également un générateur de données numériques pseudoaléatoires basé sur un tel oscillateur qui pallie tout ou partie des inconvénients des générateurs connus.

L'invention vise notamment à rendre le flux généré indépendant de valeurs discrètes de différentes sources de courant.

Pour atteindre tout ou partie des ces objets ainsi que d'autres, la présente invention prévoit un générateur d'un flux numérique pseudoaléatoire comportant un oscillateur à polarisation commandable, comportant une source de polarisation analogique commandée par un signal à variations continues en amplitude et dans le temps.

Selon un mode de réalisation de la présente invention, ladite source de polarisation est commandée par un circuit échantillonneur-bloqueur d'un signal périodique à plus de deux niveaux d'amplitude, les instants d'échantillonnage étant fixés par un détecteur de seuil d'une source de signal pseudoaléatoire.

Selon un mode de réalisation de la présente invention, le signal périodique est fourni par un générateur triangulaire.

Selon un mode de réalisation de la présente invention, la plage d'amplitudes de la source de polarisation est fixée par l'amplitude du signal triangulaire.

Selon un mode de réalisation de la présente invention, ladite source de signal pseudoaléatoire est un oscillateur chaotique, de préférence à plusieurs bassins d'attraction.

Selon un mode de réalisation de la présente invention, la plage des variations temporelles de la polarisation de l'oscillateur à polarisation commandable est fixée par la plage d'intervalles possibles entre les sauts d'un bassin d'attraction à un autre de l'oscillateur chaotique.

Selon un mode de réalisation de la présente invention, la valeur maximum de la plage de variations temporelles de la polarisation de l'oscillateur à polarisation commandable est choisie pour être inférieure au temps de stabilisation de cet oscillateur, de façon à obtenir un générateur de données numériques pseudoaléatoires.

Selon un mode de réalisation de la présente invention, la valeur minimum de la plage de variations temporelles de la polarisation de l'oscillateur à polarisation commandable est choisie pour être supérieure au temps de stabilisation de cet oscillateur de façon à obtenir un générateur d'un signal d'horloge à sauts fréquentiels pseudoaléatoires.

L'invention prévoit également un procédé de commande d'un générateur d'un flux numérique pseudoaléatoire, consistant à commander la polarisation de l'oscillateur polarisable au moyen d'un signal en paliers dont la durée des paliers varie de façon pseudoaléatoire et continue dans un intervalle donné et dont l'amplitude des paliers varie également de façon pseudoaléatoire et continue dans un intervalle donné.

### Brève description des dessins

Ces objets, caractéristiques et avantages, ainsi que d'autres de la présente invention seront exposés en détail dans la description suivante de modes de mise en oeuvre et de réalisation particuliers faite à titre non-limitatif en relation avec les figures jointes parmi lesquelles :
les figures 1 et 2 qui ont décrites précédemment sont destinées à exposer l'état de la technique et le problème posé ;
la figure 3 est une vue très schématique et sous forme de blocs d'un mode de réalisation fonctionnel d'un oscillateur selon la présente invention ;
la figure 4 représente un exemple d'allure de signal de commande d'une source de courant d'un oscillateur pseudoaléatoire selon l'invention ;
la figure 5 représente, de façon très schématique et sous forme de blocs, un mode de réalisation d'un circuit de commande d'un oscillateur pseudoaléatoire selon la présente invention ;
la figure 6 est un exemple d'une source pseudoaléatoire du circuit de la figure 5 ; et
les figures 7A, 7B, 7C, 7D et 7E illustrent, par des chronogrammes, un exemple d'allure de signaux en différents points du circuit de la figure 5.

Les mêmes éléments ont été désignés par les mêmes références aux différentes figures. Pour des raisons de clarté, seuls les éléments qui sont utiles à la compréhension de l'invention ont été représentés aux figures et seront décrits par la suite. En particulier, l'exploitation faite d'un signal numérique pseudoaléatoire généré par l'oscillateur de l'invention n'a pas été détaillée, l'invention étant compatible avec toute exploitation classique d'un flux pseudoaléatoire.

### Description détaillée

Une caractéristique d'un mode de réalisation de la présente invention est de remplacer les sources de courant commandées numériquement pour polariser un oscillateur, par une source de courant commandable par un signal analogique pseudoaléatoire.

Une autre caractéristique d'un mode de réalisation de la présente invention est de commander cette source de courant de façon à obtenir un courant de polarisation à variations continues en amplitude et dans le temps.

De préférence, le signal de commande de la source de courant est rendu équiprobable.

La figure 3 représente, de façon très schématique, un mode de réalisation d'un générateur d'un flux numérique pseudoaléatoire selon la présente invention. On retrouve un oscillateur 2 (OSC) alimenté par une tension Vdd fournissant le flux numérique Vout. Selon l'invention, cet oscillateur 2 est polarisé par une source de courant 5 à commande analogique au moyen d'un signal CTRL susceptible de faire varier l'amplitude et la fréquence de façon pseudoaléatoire sur des intervalles bornés continus.

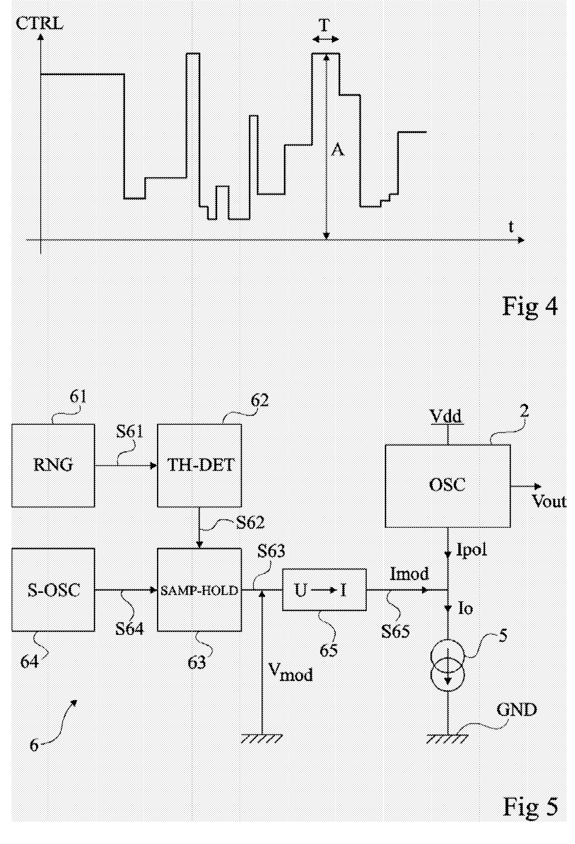

La figure 4 illustre un exemple préféré de signal de commande CTRL de la source de courant 5 de la figure 3.

Selon ce mode de réalisation préféré de l'invention, le signal CTRL est un signal en paliers susceptible de varier non seulement en amplitude mais également en fréquence de commutation. La largeur temporelle T des différents paliers varie de façon pseudoaléatoire sur un intervalle continu borné et l'amplitude A de ces paliers varie également de façon pseudoaléatoire sur un intervalle continu borné. Il en résulte que le signal de sortie de l'oscillateur 2 présente des sauts de fréquence intervenant à des instants pseudoaléatoires, entre des valeurs de fréquence elles-mêmes pseudoaléatoires.

Avec une valeur maximum des intervalles entre les sauts de fréquence (donc une plage de variation en fréquence choisie) inférieure ou égale au temps de stabilisation de l'oscillateur, le signal de sortie Vout peut être échantillonné à fréquence fixe pour obtenir un flux de données numériques pseudoaléatoires.

Avec une valeur minimum des intervalles entre les sauts de fréquence supérieure au temps de stabilisation de l'oscillateur, le signal Vout constitue un signal d'horloge à sauts fréquentiels pseudoaléatoires.

La figure 5 représente, de façon très schématique et sous forme de blocs, un exemple d'architecture d'un générateur pseudoaléatoire selon un mode de réalisation préféré de la présente invention. On retrouve l'oscillateur 2 polarisable par la source de courant 5 entre une borne d'application de la tension d'alimentation Vdd et la masse GND.

Dans cet exemple, le circuit de génération du signal CTRL de commande comporte une source 61 de signal pseudoaléatoire (RNG), un détecteur 62 d'un ou plusieurs seuils (TH-DET), un échantillonneur-bloqueur 63 (SAMP-HOLD), un générateur de signal analogique 64 (S-OSC), un convertisseur tension-courant 65 (U->I), par exemple un transistor MOS ou un amplificateur de transconductance (OTA), et une source 5 de courant constant I0. La source 5 fixe la fréquence moyenne de l'oscillateur 2. La variation du courant Ipol de polarisation de l'oscillateur 2 est obtenue en faisant varier le courant Imod fourni par l'élément 65, qui s'ajoute au courant fixe I0.

La sortie S61 de la source pseudoaléatoire 61 est connectée en entrée du détecteur de seuils 62. Il en résulte que chaque traversée d'un seuil par le signal pseudoaléatoire S61 se traduit par un changement d'état en sortie S62 du détecteur 62. De préférence, le détecteur de seuil détecte les franchissements d'un même seuil (ou de plusieurs seuils) dans les deux sens par le signal S61. La sortie S62 passe d'un état inactif à un état actif pendant un bref instant à chaque franchissement de ce seuil. Ce signal S62 commande l'échantillonneur-bloqueur 63 dont l'entrée est connectée à la sortie S64 du générateur de signal analogique 64. La sortie S63 de l'échantillonneur-bloqueur fournit une tension Vmod au convertisseur 65 dont la sortie S65 fournit le courant de modulation Imod.

Fonctionnellement, la sortie du générateur 64 est échantillonnée à des instants pseudoaléatoires par l'échantillonneur-bloqueur 63 à chaque fois que le signal de sortie de la source 61 franchit le seuil fixé par le détecteur 62.

Selon un mode de réalisation préféré de l'invention, le générateur 61 est un oscillateur chaotique. Les signaux générés par ce type d'oscillateur présentent l'avantage d'être pseudoaléatoires et très sensibles aux variations des conditions initiales (effet papillon). Les conditions initiales sont fixées par des paramètres physiques sensibles aux conditions de fonctionnement et notamment à la température. On obtient donc des séquences différentes les unes des autres. On utilisera préférentiellement un oscillateur à deux bassins d'attraction dont le passage d'un bassin à un autre s'effectue de façon imprévisible en fonction des conditions initiales. Les défauts intrinsèques à l'oscillateur (gigue de phase, bruit thermique, etc.) participent également à l'augmentation de l'entropie du flux numérique généré.

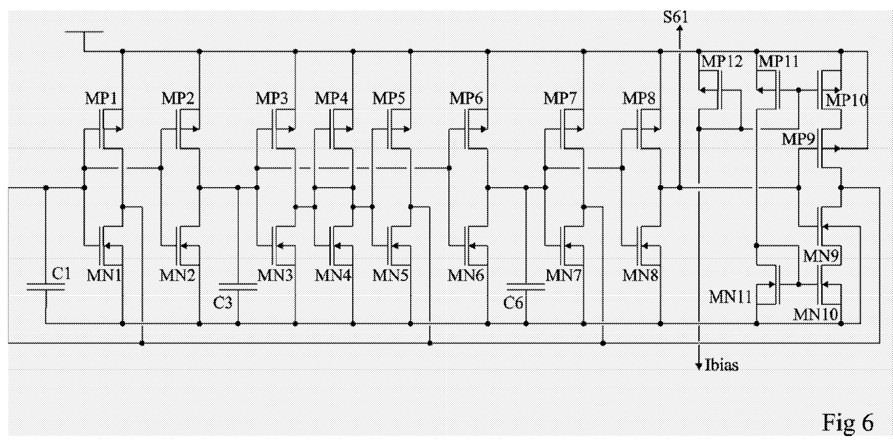

La figure 6 représente le schéma électrique d'un exemple d'oscillateur chaotique 61 à deux bassins d'attraction. Un tel oscillateur comporte, par exemple, neuf branches parallèles de transistors MOS entre une borne d'application de la tension Vdd et la masse. Huit branches comportent chacune un transistor MOS à canal P MP1 à MP8 en série avec un transistor MOS à canal N MN1 à MN8. Une neuvième branche comporte en série deux transistors MOS à canal P MP10 et MP9, et deux transistors MOS à canal N MN9 et MN10. La grille de chaque transistor MPj (j étant compris entre 1 et 9) est reliée à la grille du transistor à canal N MNj correspondant. Trois condensateurs C1, C3 et C7 relient à la masse les grilles communes respectives des transistors MP1 et MN1, MP3 et MN3, MP7 et MN7. Les grilles des transistors des deux premières branches sont reliées ensemble de même que les grilles des transistors des troisième et sixième branches, des quatrième et cinquième branches, des septième et huitième branches. Le point milieu entre les transistors MP1 et MN1 est relié aux grilles de ces transistors. Le point milieu entre les transistors MP2 et MN2 est relié aux grilles de la troisième branche. Le point milieu entre les transistors MP3 et MN3 est relié aux grilles des quatrième et cinquième branches, et au point milieu entre les transistors MP4 et MN4. Les points milieux respectifs entre les transistors MP5 et MN5, MP7 et MN7, MP9 et MN9, sont reliés aux grilles de la première branche. Le point milieu entre les transistors MP6 et MN6 est relié aux grilles des septième et huitième branches. Le point milieu entre les transistors MP8 et MN8 est relié aux grilles des transistors MP9 et MN9 de la neuvième branche et constitue la sortie S61 de l'oscillateur chaotique. Les transistors MP10 et MN10 sont respectivement montés en miroir de courant sur des transistors MP12 à canal P et MN11 à canal N, le transistor MN11 étant en série avec un transistor MP11 monté en miroir de courant sur le transistor MP12. Le drain du transistor MP12 est relié à une source de polarisation (non représentée) à laquelle il fournit un courant Ibias. Les substrats (bulk) respectifs des transistors à canal P sont reliés à la tension Vdd tandis que les substrats des transistors à canal N sont reliés à la masse.

Le circuit de la figure 6 constitue un exemple et d'autres oscillateurs chaotiques pourront être envisagés, la réalisation pratique d'un oscillateur chaotique étant elle-même connue et décrite, par exemple, dans les articles suivants :
"Construction of Classes of Circuit-Independent Chaotic Oscillators Using Passive-Only Nonlinear Devices" de Ahmed S. Elwakil et Michael Peter Kennedy, paru en mars 2001 dans IEEE Transactions on Circuits and Systems-I: Fundamental Theory and Applications, vol. 48, No. 3 (pages 289-307) ;
"MOS Realization of the Double-Scroll-Like Chaotic Equation", de Ahmed G. Radwan, Ahmed M. Soliman et Abdel-Latif El-Sedeek, paru en février 2003 dans IEEE Transactions on Circuits and Systems-I: Fundamental Theory and Applications, vol. 50, No. 2 (pages 285-288) ; et
"Design and Analysis of Multiscroll Chaotic Attractors From Saturated Function Series" de Jinhu Lü, Guanrong Chen, Xinghuo Yu et Henry Leung, paru en décembre 2004 dans IEEE Transactions on Circuits and Systems-I: Fundamental Theory and Applications, vol. 51, No. 12 (pages 2476-2490).

Le nombre de seuils détectés par le circuit 62 dépend du nombre de bassins d'attraction de l'oscillateur chaotique. Dans le cas d'un oscillateur à deux bassins d'attraction, on choisira un seul seuil préférentiellement égal à la moitié de l'amplitude maximale de tension du signal S61.

En variante, l'oscillateur chaotique est remplacé par un microprocesseur pourvu d'un algorithme numérique pseudoaléatoire de génération d'un signal à destination du détecteur de seuil 62.

Selon un mode de réalisation préféré de l'invention, le générateur de signal analogique 64 est un générateur de signal triangulaire qui présente l'avantage d'apporter un caractère équiprobable aux instants d'échantillonnage du circuit 63. La réalisation d'un générateur de signal triangulaire est à la portée de l'homme du métier. En variante, le générateur 64 fournira un signal périodique quelconque (par exemple un signal sinusoïdal ou en escalier), à plus de deux niveaux d'amplitude pour exclure un signal en créneaux (train d'impulsions) qui romprait le caractère pseudoaléatoire de l'échantillonnage.

Le signal S64 est fourni par le générateur analogique 64 à l'échantillonneur-bloqueur. Le signal S63 de sortie de l'échantillonneur-bloqueur est moyenné en entrée du convertisseur 65 qui convertit en courant les écarts par rapport à la valeur moyenne détectée. Le convertisseur 65 est, par exemple, un amplificateur opérationnel à transconductance (OTA) utilisé dans une plage de variation linéaire du gain en transconductance.

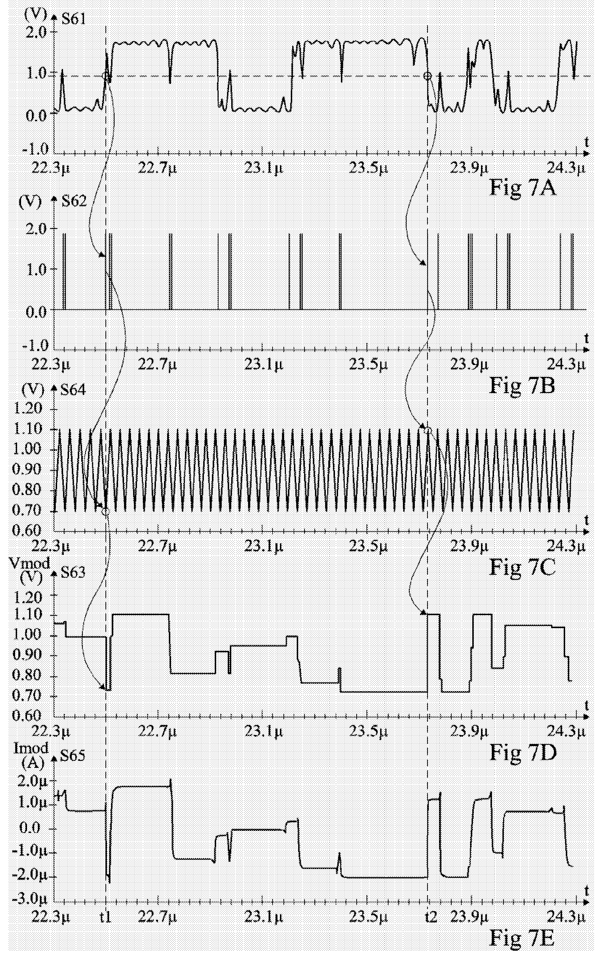

Les figures 7A, 7B, 7C, 7D et 7E illustrent, par des chronogrammes, le fonctionnement du circuit de la figure 5. Ces figures représentent des exemples d'allure respectivement en sortie S61 de l'oscillateur chaotique 61, en sortie S62 du détecteur de seuil 62, en sortie S64 du générateur analogique 64, en sortie S63 de l'échantillonneur-bloqueur 63 et le courant Imod de sortie S65 du convertisseur 65 modulant le courant de polarisation de l'oscillateur 2. Aux figures 7A à 7E, deux pointillés verticaux font ressortir des instants t1 et t2.

Dans cet exemple, on suppose un seuil du détecteur 62 à un niveau de 900 millivolts sur une plage d'amplitude de 1,8 volts du signal S61. A chaque fois que le signal S61 passe le seuil, que ce soit dans un sens ou dans un autre, le détecteur 62 fournit un front sur sa sortie S62.

Ces fronts servent à échantillonner le signal triangulaire S64. En sortie S63 de l'échantillonneur-bloqueur, on obtient un signal Vmod en paliers dont non seulement l'amplitude varie de façon continue dans la plage de tensions possibles (ici de 600 millivolts à 1,2 volts) fixée par l'amplitude du signal S64, mais également la durée varie de façon continue dans la plage de durées possibles (ici de 25 à 2000 nanosecondes). Cette plage de durées est fixée par la plage d'intervalles possibles entre les sauts d'un bassin d'attraction à l'autre de l'oscillateur chaotique (valeurs des condensateurs C1, C3 et C7 et la transconductance des transistors CMOS de la figure 5) qui conditionne la plage d'intervalles possibles entre deux fronts du signal S62 du détecteur de seuil.

Le courant de polarisation Ipol de l'oscillateur 2 se retrouve directement lié au signal en paliers Imod (S65). Comme ce signal est pseudoaléatoire et à variation continue en temps et en amplitude, il en est de même pour la polarisation de l'oscillateur 2. Ainsi, le signal Vout de sortie fourni par l'oscillateur présente un caractère pseudoaléatoire équiprobable. On obtient alors, avec une valeur moyenne des intervalles temporels inférieure au temps de stabilisation de l'oscillateur, un flux de données numériques pseudoaléatoires (non représenté).

Dans le cas d'une valeur moyenne des intervalles entre les sauts de fréquence supérieure au temps de stabilisation de l'oscillateur, sa sortie transite de façon quasialéatoire entre des états stables pseudoaléatoires. On obtient alors un signal d'horloge qui peut être utilisé pour cadencer un système numérique (par exemple, un système cryptographique) afin de masquer ces signatures en courant.

Bien entendu, la présente invention est susceptible de diverses variantes et modifications qui apparaîtront à l'homme de l'art. En particulier, la réalisation pratique des circuits constitutifs d'un générateur selon l'invention est à la portée de l'homme du métier à partir des indications fonctionnelles données ci-dessus et en utilisant des circuits en eux-mêmes connus. De plus, les choix des fréquences des différents signaux pour obtenir le flux numérique pseudoaléatoire en fonction de l'application sont également à la portée de l'homme du métier.

## Revendications

1. Générateur d'un flux numérique pseudoaléatoire comportant un oscillateur (2) à polarisation commandable, **caractérisé en ce qu'**il comporte une source de polarisation analogique (5) commandée par un signal (CTRL, Imod) à variations continues en amplitude et dans le temps, ladite source de polarisation (5) étant commandée par un circuit échantillonneur-bloqueur (63) d'un signal périodique (S64) à plus de deux niveaux d'amplitude.

2. Générateur selon la revendication 1, dans lequel les instants d'échantillonnage de ladite source de polarisation (5) sont fixés par un détecteur de seuil (62) d'une source (61) de signal pseudoaléatoire.

3. Générateur selon la revendication 2, dans lequel le signal périodique (S64) est fourni par un générateur triangulaire (64).

4. Générateur selon la revendication 3, dans lequel la plage d'amplitudes de la source de polarisation (5) est fixée par l'amplitude du signal triangulaire.

5. Générateur selon l'une quelconque des revendications 2 à 4, dans lequel ladite source de signal pseudoaléatoire (S61) est un oscillateur chaotique (61), de préférence à plusieurs bassins d'attraction.

6. Générateur selon la revendication 5, dans lequel la plage des variations temporelles de la polarisation de l'oscillateur à polarisation commandable (2) est fixée par la plage d'intervalles possibles entre les sauts d'un bassin d'attraction à un autre de l'oscillateur chaotique (61).

7. Générateur selon l'une quelconque des revendications 1 à 6, dans lequel la valeur maximum de la plage de variations temporelles de la polarisation de l'oscillateur à polarisation commandable (2) est choisie pour être inférieure au temps de stabilisation de cet oscillateur, de façon à obtenir un générateur de données numériques pseudoaléatoires.

8. Générateur selon l'une quelconque des revendications 1 à 6, dans lequel la valeur minimum de la plage de variations temporelles de la polarisation de l'oscillateur à polarisation commandable (2) est choisie pour être supérieure au temps de stabilisation de cet oscillateur de façon à obtenir un générateur d'un signal d'horloge à sauts fréquentiels pseudoaléatoires.

9. Procédé de commande d'un générateur d'un flux numérique pseudoaléatoire selon la revendication 1, **caractérisé en ce qu'**il consiste à commander la polarisation de l'oscillateur polarisable (2) au moyen d'un signal en paliers dont la durée (T) des paliers varie de façon pseudoaléatoire et continue dans un intervalle donné et dont l'amplitude (A) des paliers varie également de façon pseudoaléatoire et continue dans un intervalle donné.
